# EUROPEAN PATENT APPLICATION

(11) **EP 4 332 631 A1**
(43) Date of publication of application: **06.03.2024**
(21) Application number: 23193908.3
(22) Date of filing: 29.08.2023
(51) Int. Cl.: G01S 17/86, G01S 17/88, G01S 17/89

(54) **GLOBAL OPTIMIZATION METHODS FOR MOBILE COORDINATE SCANNERS**

(30) Priority: 31.08.2022 US 202263402496 P; 21.07.2023 US 202318356871
(71) Applicant: Faro Technologies, Inc., Lake Mary, FL 32746-6204 (US)
(72) Inventor: FRANK, Aleksej, 70825 Korntal-Münchingen (DE); WAHEED, Mufassar, 70825 Korntal-Münchingen (DE); WOLKE, Matthias, 70825 Korntal-Münchingen (DE); BRENNER, Mark, 70825 Korntal-Münchingen (DE)
(74) Representative: Müller Schupfner & Partner Patent- und Rechtsanwaltspartnerschaft mbB

(57) **Abstract**

A mobile three-dimensional (3D) measuring system includes a 3D measuring device (120) to capture 3D data in a multi-level architecture (e.g., a building), and an orientation sensor to estimate an altitude. One or more processing units coupled with the 3D measuring device and the orientation sensor perform a method that includes receiving a first portion of the 3D data captured by the 3D measuring device. The method further includes determining a level index based on the altitude. The level index indicates a level of the multi-level architecture at which the first portion is captured. The level index is associated with the first portion. Further, a map of the multi-level architecture is generated using the first portion, the generating comprises registering the first portion with a second portion of the 3D data responsive to the level index of the first portion being equal to the level index of the second portion. A "constraint" refers to a part/point in the environment that is scanned multiple times, and hence can be used as a reference. Aspects of the technical solutions facilitate differentiating between single-level constraints (i.e., similarities that are physically located on the same level/floor) and multi-level constraints (i.e., similarities among portions of physically different levels/floors). If similar portions are found and captured on the same floor, these are registered with each other. An operator carries a scanner (120) which includes two sensors (122, 126) mounted on supporting mounts (2).

## Description

### CROSS-REFERENCE OF RELATED APPLICATIONS

This application claims the benefit of U.S. Provisional Patent Application serial no. 63/402,496, filed August 31, 2022, and entitled "GLOBAL OPTIMIZATION METHODS FOR MOBILE COORDINATE SCANNERS," the contents of which are incorporated by reference herein in its entirety.

### BACKGROUND

The present disclosure relates to a system and method that can facilitate measuring, capturing, and storing a three-dimensional (3D) representation of a surrounding environment using a mobile/portable coordinate measurement device, particularly to optimization techniques to improve data capturing by such a measurement device.

The subject matter disclosed herein relates to a 3D coordinate measurement device, sometimes also referred to as a 3D scanner, a 3D laser scanner, a laser scanner, a scanner, or equivalent terms thereof. Such a scanner can be a time-of-flight (TOF) or a phase shift coordinate measurement device. A TOF laser scanner steers a beam of light to a non-cooperative target, such as a diffusely scattering surface of an object. A distance meter in the device measures the distance to the object, and angular encoders measure the angles of the emitted light. The measured distance and angles enable a processor in the device to determine the 3D coordinates of the target. A TOF laser scanner (or simply TOF scanner) is a scanner in which the distance to a target point is determined based on the speed of light in the air between the scanner and a target point. Phase shift laser scanners determine the distance to the object by the phase shift between the outgoing and returning signal (i.e., calculating the "shift" or "displacement" of the reflective wave compared to the outgoing wave).

Laser scanners are typically used for scanning closed or open spaces such as interior areas of buildings, industrial installations, and tunnels. They may be used, for example, in industrial applications and accident reconstruction applications. A laser scanner optically scans and measures objects in a volume around the scanner by acquiring data points representing object surfaces within the volume. Such data points are obtained by transmitting a beam of light onto the objects and collecting the reflected or scattered light to determine the distance, two angles (i.e., azimuth and a zenith angle), and optionally a gray-scale value. This raw scan data is collected, stored, and sent to a processor or processors to generate a 3D image representing the scanned area or object.

Generating an image requires at least three values for each data point. These three values may include the distance and two angles or maybe transformed values, such as the x, y, z coordinates. In an embodiment, an image is also based on a fourth gray-scale value, which is a value related to the irradiance of scattered light returning to the scanner.

Most scanners direct the beam of light within the measurement volume by steering the light with a beam steering mechanism. The beam steering mechanism includes a first motor that steers the beam of light about a first axis by a first angle that is measured by a first angular encoder (or another angle transducer). The beam steering mechanism also includes a second motor that steers the beam of light about a second axis by a second angle that is measured by a second angular encoder (or another angle transducer).

Many contemporary laser scanners include a camera mounted on the laser scanner for gathering digital images of the environment and presenting the digital camera images to an operator of the laser scanner. By viewing the camera images, the operator of the scanner can determine the field of view of the measured volume and adjust settings on the laser scanner to measure over a larger or smaller region of space. In addition, the camera's digital images may be transmitted to a processor to add color to the scanner image. To generate a color scanner image, at least three positional coordinates (such as x, y, z) and three color values (such as red, green, blue "RGB") are collected for each data point.

A 3D image of a scene may require multiple scans from different registration stationary positions. The overlapping scans are registered in a joint coordinate system, for example, as described in U.S. Published Patent Application No. 2012/0069352 (`352), the contents of which are incorporated herein by reference. Such registration is performed by matching targets in overlapping regions of the multiple scans. The targets may be artificial targets such as spheres, checkerboards, or natural features such as corners or edges of walls. Some registration procedures involve relatively time-consuming manual procedures such as identifying by a user each target and matching the targets obtained by the scanner in each of the different registration positions. Some registration procedures also require establishing an external "control network" of registration targets measured by an external device such as a total station. The registration method disclosed in `352 eliminates the need for user matching of registration targets and establishing a control network.

A laser scanner is usually mounted on a tripod or instrument stand while measuring the 3D coordinates of its surroundings. An operator is required to move the tripod from location to location as measurements are taken.

In some cases, a scanner can be a portable device having a projector that projects light patterns on the surface of an object to be scanned. One (or more) cameras, having a predetermined positions and alignment relative to the projector, records images of the light pattern on the surface of an object. The three-dimensional coordinates of elements in the light pattern can be determined by trigonometric methods, such as by using triangulation. Other types of 3D measuring devices may also be used to measure 3D coordinates, such as those that use time of flight techniques (e.g., laser trackers, laser scanners or time of flight cameras) for measuring the amount of time it takes for light to travel to the surface and return to the device.

Accordingly, while existing portable 3D coordinate measurement devices are suitable for their intended purpose the need for improvement remains, particularly in providing a coordinate measurement device having the features described herein.

### BRIEF DESCRIPTION

According to one or more aspects, a mobile three-dimensional (3D) measuring system includes a 3D measuring device configured to capture 3D data in a multi-level architecture. The mobile 3D measuring system further includes an orientation sensor configured to estimate an altitude of the 3D measuring system. The mobile 3D measuring system further includes one or more processing units coupled with the 3D measuring device and the orientation sensor. The one or more processing units configured to perform a method that includes receiving a first portion of the 3D data captured by the 3D measuring device. The method further includes determining a level index based on the altitude estimated by the orientation sensor, the level index indicates a level of the multi-level architecture at which the first portion of the 3D data is captured. The method further includes associating the level index with the first portion. The method further includes generating a map of the multi-level architecture using the first portion, the generating comprises registering the first portion with a second portion of the 3D data responsive to the level index of the first portion being equal to the level index of the second portion.

In one or more aspects, the 3D measuring device comprises a LIDAR sensor to capture a digital representation of the multi-level architecture as the 3D measuring system is transported in the multi-level architecture.

In one or more aspects, the 3D measuring device continuously transmits a captured data to a computing system as the 3D measuring device is moved in the multi-level architecture, the computing system comprising the one or more processing units.

In one or more aspects, the computing system generates a 3D point cloud representing the multi-level architecture based on the captured data and stores the 3D point cloud.

In one or more aspects, the 3D measuring device is configured for wireless communication with the computing system.

In one or more aspects, the orientation sensor comprises a gyroscope, an accelerometer, and magnetometer.

In one or more aspects, determining the level index for the first portion includes monitoring the altitude estimated by the orientation sensor, and incrementing a previous level index in response to the altitude estimated by the orientation sensor increasing at least by a predetermined threshold. In one or more aspects, determining the level index also includes decrementing the previous level index in response to the altitude estimated by the orientation sensor decreasing at least by the predetermined threshold.

In one or more aspects, the previous level index is an initial level index that is configured prior to scanning the multi-level architecture and according to the level at which the scanning is initiated.

In one or more aspects, determining the level index for the first portion comprises an operator entering the level index.

In one or more aspects, the level index is associated with the first portion in response to the level index being changed to a second level index.

In one or more aspects, the level index is associated with the first portion captured by the 3D measuring device in a continuous manner.

In one or more aspects, associating the level index with the first portion comprises storing the level index in a metadata of a digital representation of the first portion.

In one or more aspects, registering the first portion with the second portion includes determining a transformation to be applied to the first portion to compensate for a drifting error, and limiting the transformation to only a horizontal plane. Further, transforming the first portion based on the transformation that is limited.

In one or more aspects, the transformation is determined based on one or more constraints.

In one or more aspects, the one or more constraints are based on one or more corresponding features of the first portion and the second portion.

According to an embodiment, a computer-implemented method is provided. The method includes receiving a first portion of 3D data captured by a 3D measuring device, the 3D data captured in a multi-level architecture. The method further includes determining a level index based on an altitude of the 3D measuring device estimated by an orientation sensor, the level index indicating a level of the multi-level architecture at which the first portion of the 3D data is captured. The method further includes associating the level index with the first portion. The method further includes generating a map of the multi-level architecture using the first portion, the generating comprises registering the first portion with a second portion of the 3D data responsive to the level index of the first portion being equal to the level index of the second portion.

In one or more aspects, the 3D measuring device comprises a LIDAR sensor to capture a digital representation of the multi-level architecture as the 3D measuring system is transported in the multi-level architecture.

In one or more aspects, the orientation sensor comprises a gyroscope, an accelerometer, and magnetometer.

In one or more aspects, determining the level index for the first portion comprises: monitoring the altitude estimated by the orientation sensor; incrementing a previous level index in response to the altitude estimated by the orientation sensor increasing at least by a predetermined threshold; and decrementing the previous level index in response to the altitude estimated by the orientation sensor decreasing at least by the predetermined threshold, wherein the previous level index is an initial level index that is configured prior to scanning the multi-level architecture and according to the level at which the scanning is initiated.

In one or more aspects, registering the first portion with the second portion comprises: determining a transformation to be applied to the first portion to compensate for a drifting error; limiting the transformation to only a horizontal plane; and transforming the first portion based on the transformation that is limited, wherein the transformation is determined based on one or more constraints, and wherein the one or more constraints are based on one or more corresponding features of the first portion and the second portion.

These and other advantages and features will become more apparent from the following description taken in conjunction with the drawings.

### BRIEF DESCRIPTION OF THE DRAWINGS

The subject matter, which is regarded as the invention, is particularly pointed out and distinctly claimed in the claims at the conclusion of the specification. The foregoing and other features, and advantages of embodiments of the invention are apparent from the following detailed description taken in conjunction with the accompanying drawings in which:
FIG. 1 depicts an example 3D measurement device/apparatus according to one or more aspects;
FIG. 2 depicts a scanning system for capturing measurements in an environment according to one or more aspects;
FIG. 3 depicts a block diagram of a structure of the processing performed by the scanning system 100 to generate map 130 according to one or more aspects;
FIG. 4 depicts an example point cloud;
FIG. 5 depicts a flowchart of a method for generating the map of a surrounding environment as the measurement device is transported in the surrounding environment according to one or more aspects;
FIGS. 6A and 6B depict an example scenario that illustrates the technical challenge described with present mapping algorithms;
FIG. 7 depicts a resulting point cloud that is created using aspects of the technical solutions described herein;
FIG. 8 depicts a flowchart of a method to create single-level and multi-level constraints according to one or more aspects;
FIG. 9 depicts an example scenario where constraints are filtered based on being consistent or inconsistent according to one or more aspects; and
FIG. 10 depicts a computer system in accordance with one or more aspects.

The detailed description explains embodiments of the invention, together with advantages and features, by way of example with reference to the drawings.

### DETAILED DESCRIPTION

Aspects of the technical solutions described herein provide a system, a device, or an apparatus that includes a mobile 3D scanner that can include one or more sensors, such as light detection and ranging (LIDAR) sensors ("LIDAR"), Time-of-Flight (TOF) sensors, or structured light sensors. The sensors can be commercially available components, for example, devices manufactured by VELODYNE^{®} or any other manufacturer. The 3D scanner uses the sensors to capture a surrounding environment's digital three-dimensional (3D) representation. In one or more aspects, the 3D scanner can be carried, for example, as a handheld device that facilitates measuring, capturing, and storing the 3D representation of the surrounding environment. In other aspects, the 3D scanner can be carried, for example, mounted to an autonomous/semi-autonomous moveable platform/vehicle, such as a robot, a vehicle, on an operator, etc. The 3D scanner can include additional sensors, such as a camera, an inertial measurement unit (IMU), an accelerometer, a global positioning system (GPS), etc.

It should be noted that the "portability" or the "mobility" of the 3D scanner facilitates continuously capturing the digital representation of the surrounding environment as the 3D scanner is moved in an environment (for example, as the operator walks, vehicle drives, etc.). Instead, in existing solutions, the 3D scanner would be placed at a first position in the environment to capture a first portion of the surrounding environment, then moved to a second position in the environment to capture a second portion, and so on. The two or more digital representations captured from the respective positions, are then registered with each other to generate a map of the surrounding environment in the existing solutions.

By facilitating continuous capturing of the surrounding, the technical solutions described herein improve the speed at which the map (i.e., the 3D digital representation) is generated. For example, the time and effort required to move and place the 3D scanner from one position to another are reduced. Further, the continuous capturing reduces skipped or uncaptured areas because the 3D scanner could not be placed at a suitable position to capture an area. For example, areas behind an obstacle (e.g., column, wall, etc.), inside a cabinet/closet, maybe unreachable for stationary 3D scanners because of limited positions where a tripod or fixture can be placed.

The portability/mobility of the 3D scanner, as opposed to capturing the digital representation when the 3D scanner is stationary introduces several technical challenges. One technical challenge while mapping, i.e., capturing the digital representation, is to compensate for a "drift" that occurs as the 3D scanner is moved around the environment being mapped. The source of the drift includes one or more noisy sensors, such as the LIDAR and IMU sensors in the 3D scanner. A technical solution to address such a challenge is to compensate for the drift by mapping in a way that "constraints" and "loop closures" are generated. "Loop closures" are areas/locations/positions in the environment that are revisited during mapping. The "loop closure" is typically performed by capturing measurements from the 3D scanner at the same position/location (say P) at two different timepoints (say T1 and T2), and determining a difference (delta) between the two measurements. Such a difference is considered the "drift" or error that is accumulated by the 3D scanner in the duration T1-T2 during which the 3D scanner was transported in the environment. A "constraint" refers to a part/point in the environment that is scanned multiple times, and hence can be used as a reference. It is important for a mapping algorithm to reliably detect the constraints and loop closures because, an incorrect or inconsistent constraint/loop closure can lead to an inaccurate and/or unusable representation of the environment. For example, the captured data from the 3D scanner can cause a noisy point cloud with potentially doubling effect on walls, objects, etc. technical solutions described herein facilitate techniques for optimizing the data captured during mapping to reliably detect constraints that are accurate.

The techniques described herein can be performed in real-time while the 3D scanner is capturing data. In some aspects, the techniques described herein can be performed in an offline manner (e.g. post-processing), for example, after the data is captured, and while the data is being rendered. The techniques described herein are applicable to 3D scanners that are used for "portable/mobile mapping" as described herein, although, the techniques are not limited to such applications. Further, techniques described herein can be used by the 3D scanner by performing the analysis and methods described herein locally (e.g., by the 3D scanner itself, or by a computing system that is co-located with the 3D scanner) or remotely (e.g., by a computing device/server that is remotely located from the 3D scanner/data). Further yet, the techniques described herein can be accessed as an application programming interface (API) in one or more aspects.

With mobile mapping it is possible to capture many environments due to the flexibility while mapping compared to stationary scanning. One can generate point cloud of the scanned environments for outside or inside environments. Also, one can scan even nonplanar trajectories like scanning staircases, scanning multiple level stores. Many of the mapping algorithms implement straight forward global optimization for detecting loop closures. Basically, the algorithms look for similar areas and assume both parts have to connected by a constraint and thus overlayed on top of each other. In many situations this naive implementation will lead to an inconsistent trajectory and causing incorrect point cloud. With our approach we are able to address following situations and generate consistent point clouds for those scenarios.

The technical solutions described herein provide a practical application by optimizing data that is captured by a 3D scanner. In some aspects, the technical solutions described herein facilitate optimizing the data in real-time, as the 3D scanner is capturing it. Technical solutions herein improve a 3D scanner to improve the data captured by the 3D scanner while being transported in the environment. In addition, the technical solutions described herein improve 3D scanning/mapping by improving the quality of the 3D maps that are generated by the 3D scanner. The technical solutions described herein are rooted in computing technology, and particularly provides improvements to fields of computer vision, 3D modeling, 3D/digital scanning/mapping, using one or more sensors, and other such application areas.

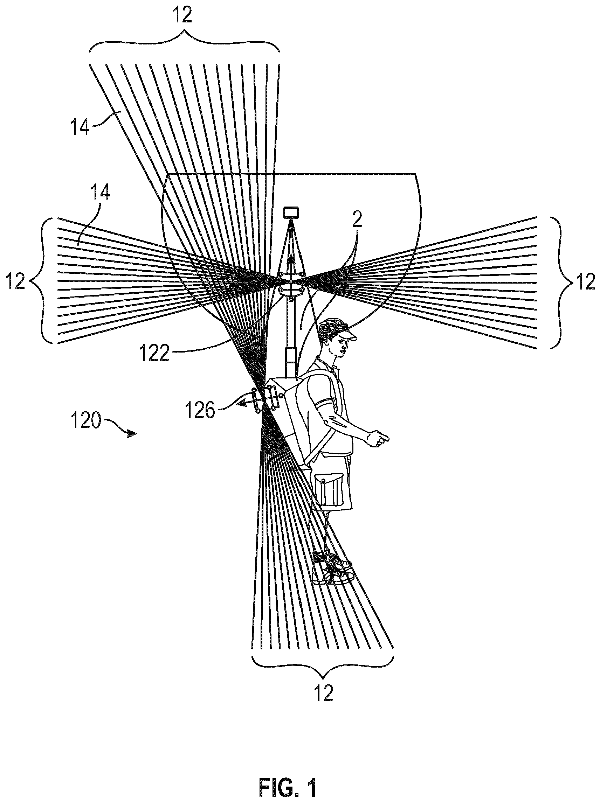

FIG. 1 depicts an example 3D measurement device/apparatus according to one or more aspects. In the depicted example, an operator carries a 3D measurement device 120 ("scanner"), which includes two sensors 122, 126. The sensors 122, 126 can include LIDAR devices or any other type of sensor. The sensor 122, such as a LIDAR device, facilitates determining the distance (ranges) of a point of an object in the sensor's field of view (FOV) by targeting the object with a light pulse (e.g., laser) and measuring the time for the reflected light to return to a receiver. The sensor 122 facilitates emitting and receiving the light pulses and measuring the time between emission and reception. The measurement device 120 can further include an IMU device 126, which facilitates calculating a force, angular rate, as well as the direction of the of the 3D scanner 120. In some examples, the IMU device 126 can include a combination of sensors like gyroscope, magnetometer, and accelerometer. Alternatively, or in addition, the sensor 126 can include an orientation sensor that is a combination of gyroscope, accelerometer, and magnetometer. The orientation sensor can estimate an orientation of the scanning system 100, and particularly the scanner 120 in one or more aspects by fusing the measurements from gyroscope, accelerometer, and magnetometer.

The sensors 122, 126 can be mounted on supporting mounts 2 in some examples. The mounting and positioning of the sensors with respect to the operator and/or each other can be different from that shown in the example of FIG. 1. Each device 122, 126 has a respective FOV 12. It should be noted that although an operator is depicted to be carrying the measurement device 120 manually (on the back/hand) in FIG. 1, in other examples, the measurement device 120 can be carried by the operator in a different manner. Further, in some examples, the measurement device 120 can be carried by a robotic/automated/semi-automated or manually moved platform.

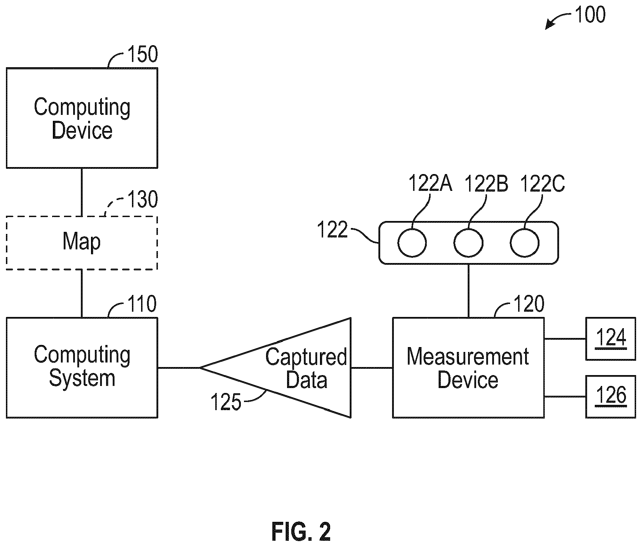

FIG. 2 depicts a scanning system for capturing measurements in an environment according to one or more aspects. The scanning system 100 includes a computing system 110 coupled with a measurement device 120. The coupling facilitates electronic communication of data and instructions between the computing system 110 and the measurement device 120. The communication can be performed in a wired or wireless manner. The measurement device 120 can be a 3D scanner. The computing system 110 can be a computer server or any other type of computing device that facilitates remote storage and processing of the captured data 125.

The captured data 125 from the measurement device 120 includes measurements of a portion of the environment. The captured data 125 is transmitted to the computing system 110 for processing and/or storage. The computing device 110 can store the captured data 125 locally, i.e., in a storage device in the computing device 110 itself, or remotely, i.e., in a storage device that is part of another computing device 150. The computing device 150 can be a computer server or any other type of computing device that facilitates remote storage and processing of the captured data 125.

The captured data 125 from the measurement device 120 can include 2D images, 3D point clouds, a distance of each point in the point cloud(s) from the measurement device 120, color information at each point, radiance information at each point, and other such sensor data captured by the set of sensors 122 of the measurement device 120. For example, sensors 122 can include a LIDAR 122A, a depth camera 122B, a camera 122C, etc. The sensors 122 may further include projectors that emit a line or a pattern of light. The sensors 122 may further include a projector and sensor that determine distance based on the time of flight of the emitted light. In some cases, the 2D images can be panorama images (e.g., wide-angle images, ultra-wide-angle images, etc.). The measurement device 120 can also include an inertial measurement unit (IMU) 126 to keep track of a pose, including a 3D orientation, of the measurement device 120. Alternatively, or in addition, for the captured data 125, the pose can be extrapolated by using the sensor data from sensors 122, the IMU 126, and/or from sensors besides the range finders.

In one or more aspects, the measurement device 120 can also include a global positioning sensor (GPS) (not shown) or another such location-sensing module that facilitates identifying a global position of the measurement device 120. While there are solutions that use photogrammetry using GPS information, for example, for scaling, such techniques have significant errors (~5-10%) because of the errors in the kinematic GPS measurement. While such techniques may be suitable for generating maps of large spaces (e.g., 5 square miles+) where lower accuracy can be compensated, such errors are not acceptable when generating a map of a relatively smaller area (e.g., an office building, a factory, an industrial floor, a shopping mall, a construction site, etc.).

It should be noted that while only a single measurement device 120 is depicted, in some aspects, multiple measurement devices 120 can transmit respective captured data 125 to the computing system 110. Each of the measurement devices 120 transmits captured data 125 to the computing system 110 concurrently in some aspects.

To address the technical challenges with existing 3D scanning systems and to facilitate capturing a map 130 of the surrounding in real-time using the mobile measurement device 120, aspects of the technical solutions described herein use distributed processing, in some aspects. The distributed processing comprises running a subset of the operations for generating the map 130 on the measurement devices 120 and another subset of the operations on the computing system 110 (i.e., a distributed or cloud platform), which can process data from the different measurement devices 120. Accordingly, the technical challenge of the limited processing power available at the measurement devices 120 (for example, necessitated by the portability) can be overcome. Further, the distributed processing facilitates updating the computing system 110 (for example, to correct errors, add features, etc.) faster than updating the (local) measurement devices 120.

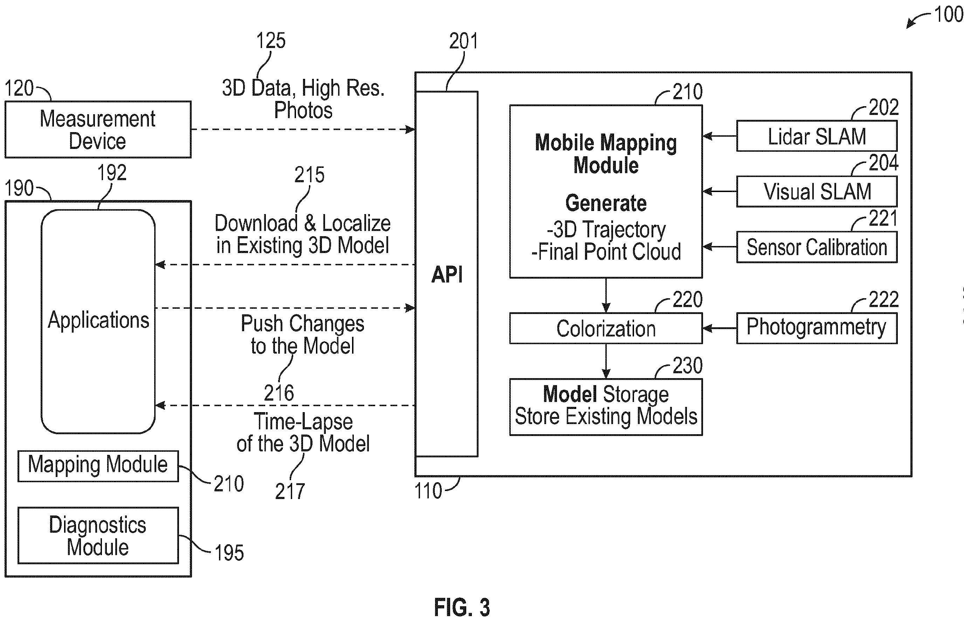

FIG. 3 depicts a block diagram of a structure of the processing performed by the scanning system 100 to generate map 130 according to one or more aspects. An example distributed computing structure is depicted; however, it is understood that the components/modules that are depicted can be structured differently in other aspects. In some aspects, one or more of the components/modules can be separated/combined.

In the illustrated structure, the measurement device 120 transmits the captured data 125 to the computing system 110, i.e., a "cloud computing system." The computing system 110 processes the captured data 125 to generate an output 215. The output 215 includes at least a portion of the map 130. In some aspects, the measurement device 120 may include one or more processing units to facilitate some computing. In such aspects, the measurement device 120 may generate a preview of mapping results in real-time using the one or more processing unit. The preview may be generated at a lower resolution (below a predetermined threshold), to budget available computing resources on the measurement device 120. Further, the computing system 110, during post-processing, may use the scanned data to generate a high resolution result. It is understood that the components of the system 100 can be combined or separated in other aspects.

In some aspects, one or more applications 192 receive the output 215. The one or more applications 190 can be software or computer programs in some aspects. The applications 192 may be executing on a computing device 190. The computing device 190 can be different from the computing system 110 in some aspects. For example, the computing device 190 can be a mobile phone, a tablet computer, a laptop computer, or any other type of portable computing device that may have limited computing resources. The computing device 190 communicates with the computing system 110 in a wired or wireless manner, for example, using a computer network, such as the Internet. In other aspects, the computing device 190 is the computing system 110 itself, or part of the computing system 110. In some examples, the computing device 190 can be the measurement device 120 itself or associated with the measurement device 120. In some aspects, the applications 192 facilitate downloading processed outputs like trajectory, point cloud and enriches such processed outputs with additional data. For example, the scanning system uses the output to localize in a prerecorded data and extends it with previously not recorded data. The output is then uploaded back to the computing system 110. As a result two models from previous time points can be obtained. Other use cases and operations are possible in other aspects.

The computing device 190, in some aspects, can transmit to the computing system 190, one or more requests 216 to change one or more portions of the map 130. The changes can be based on, for example, localization of a portion of the map 130 included in the output 215.

The computing system 110 can provide an application programming interface (API) 201 to facilitate communication with external components such as the measurement device 120 and the computing device 190. The API 201 can be accessed by the external components to provide the captured data 215, the requests 216, and to receive the output 215, the time-lapse of the 3D model 217, and other communications. Predetermined communication protocols and data structures are used to communicate the electronic data between the computing system 110 and the measurement device 120, and the computing device 190. For example, standards associated with the robot operating system (ROS) can be used for transferring the data using *.BAG file protocols. Other types of predetermined data standards can be used, such as gRPC, in other examples, and the data structures and protocols used for the communication do not limit the technical solutions described herein.

Based on the received inputs (e.g., captured data 125, requests 216, etc.), one or more components of the computing system 110 process the captured data 125. It should be understood that while one possible division of the components of the computing system 110 is depicted, in other aspects of the technical solutions, the components can be structured any other way. The computing system 110 can include a mapping module 210 that generates a trajectory of the measurement device 120 in the map 130 based on the captured data 125. The mapping module 210 can also be responsible for generating a point cloud representing the surrounding environment. In some examples, the point cloud is part of the map 130.

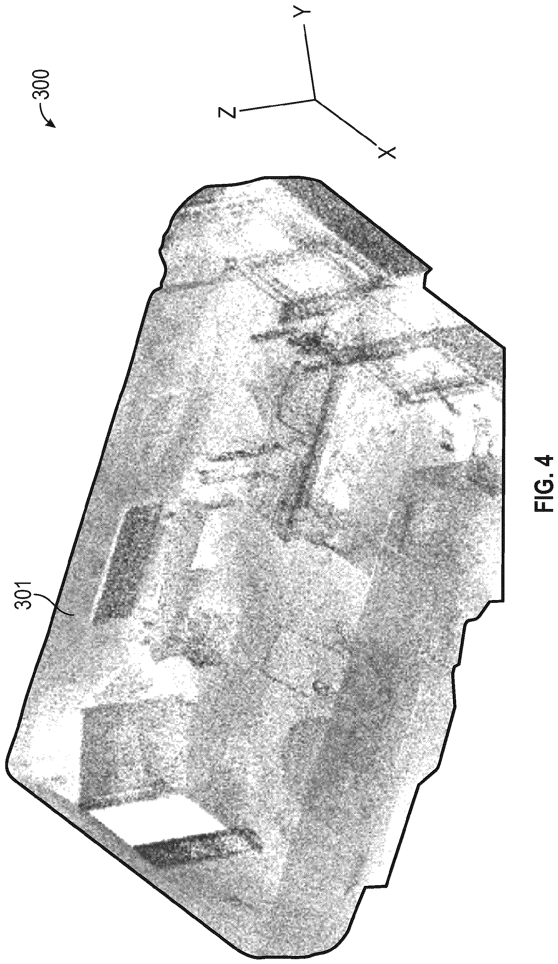

FIG. 4 depicts an example point cloud. A "point cloud" 300 is a collection of individual 3D data points 301, with each data point 301 having a set coordinate on the X, Y, and Z-axis. A 3D model can be visually represented by rendering each of the data points 301 in the point cloud 300 together. For example, in the illustrated case, the data compiled to create the point cloud 300 is taken from a room to depict the location of each door, window, and any other object (e.g., bed, rug, etc.) or surface in the room. Depending on the data points 301 captured and the density of the point cloud 300, the clarity (or quality) of details and specific types of features and structures will vary.

Referring to FIG. 3, the mapping module 210 is responsible for executing one or more simultaneous localization and mapping (SLAM) algorithms, such as LIDAR SLAM 202, visual SLAM 204, etc. The mapping module 210 uses the captured data 215. Further, the mapping module 210 uses information about the actual measurement device 120 that captured the data, i.e., which sensors were used, calibrations (e.g., sensor calibration 221), etc. With such information, the mapping module 210 performs mapping for the different types of sensors 122, i.e., LIDARs, cameras, IMUs 126, etc. The "mapping" includes aligning the measurements from the several sensors 122, 126 into a common coordinate frame of reference system as well as ensuring timestamp synchronization across the sensors. The mapping module 210 generates a 3D point cloud 300 in this manner. In some aspects, the measurement device 120 has a mapping module 210 incorporated for the generation of live preview without any assistance from the computing system 110. In such cases, the computing system 110 is used for generation of higher resolution output.

The computing system 110 further includes a colorization module 220, which, in some aspects, colorizes the 3D point cloud 300 that is generated by the mapping module 210. Colorization includes assigning a color to each data point 301 in the point cloud 300. The colorization can be performed using known techniques such as applying a "texture" using a color image captured by a camera. The color image can be a panoramic or fish-eye image in one or more examples. The color image can be aligned with the 3D point cloud 300 using photogrammetry 222 in one or more examples. Other techniques can also be used to colorize the 3D point cloud 300 in other examples.

The 3D point cloud 300 with and/or without colorization is stored by the computing system 110 in a model storage 230.

The 3D point cloud 300 is provided to the computing device 190 as part of the output 215. In one or more examples, the computing device 190 also includes an instance of the mapping module 210. In some aspects, two different instances of the same mapping module 210 are executed. A first instance can be on the measurement device 120, and a second instance on the computing system 110. Alternatively, or in addition, the first instance can be on the computing system 110, and the second instance on the computing device 190. The second instance has different (relaxed) settings from the first instance of the mapping module 210. The second instance performs a live mapping of the 3D point clouds in the output(s) 215 generated by the computing system 110. The second instance generates a preview of the map 130 using the outputs from the computing system 110. The generated preview can be 2D or 2.5D map (2.5D means a 2D image/map with depth information). Alternatively, the preview visualizes the 3D point cloud 300 with a lower predetermined resolution.

In some aspects, three instance of the mapping module 210 may be used, one instance on the measurement device 120, a second on the computing system 110, and a third instance on the computing device 190. The third instance may provide the localization workflow. For example, the scanning system 100 downloads the data from the computing system 110 uses the sensor data on board the measurement device 120 to localize in that (i.e., finding a common reference, a transformation) and extending the mapped area. As a result the downloaded data (point cloud) in the computing device 190 includes additional data: downloaded data + newly recorded one in the same coordinate system.

Additionally, the computing device 190 includes a diagnostics and logging module 195 that saves information about the settings and calibration of the computing device 190.

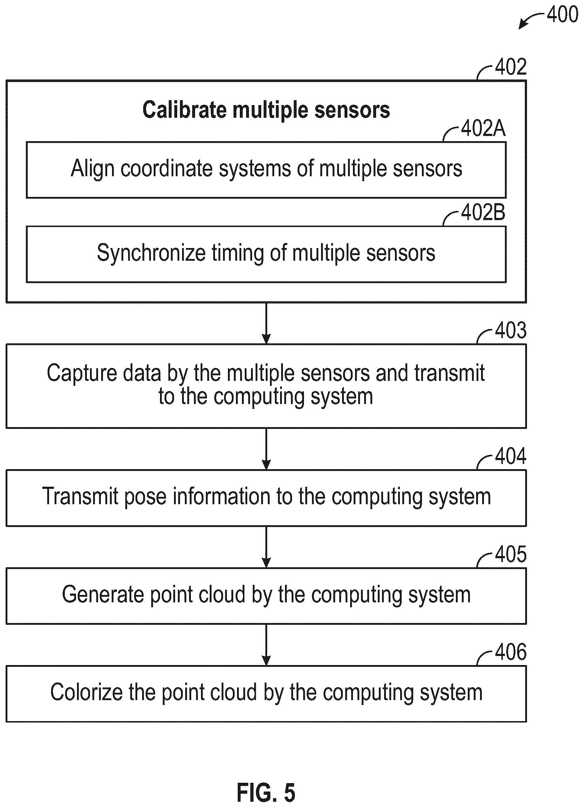

FIG. 5 depicts a flowchart of a method for generating the map of a surrounding environment as the measurement device is transported in the surrounding environment according to one or more aspects. In some aspects, the scanning system 100 provides, as feedback, a real-time preview of the map that is being generated. The method 400 includes, at block 402, calibrating the sensors 122 of the one or more measurement devices 120. At block 402A, the multiple sensors are calibrated to generate measurements on a single trajectory and a common coordinate system of a point cloud. When multiple sensors are used, the coordinate systems of the multiple sensors have to be aligned to a single common coordinate frame of reference system. For example, if the measurement device 120 includes two LIDAR sensors, the measurements from both LIDAR sensors are aligned to a common (single) coordinate system. The common coordinate frame of reference system can be that of one of the two LIDAR sensors or a third coordinate system independent of the two LIDAR sensors.

In some aspects, calibrating the sensors further includes, at block 402B, synchronizing timing across the multiple sensors 122. Timestamping the captured data from the sensors is crucial for the quality of the mapping. If the timestamps of the sensors are different in relation to each other, the processing places the captured data at positions away from each other. Several known or future developed techniques of timing synchronization can be implemented in one or more aspects.

At block 404, sensor measurements of the surrounding environment are captured by the measurement devices 120 and transmitted to the computing system 110. The measured sensor data is the captured data 125. The sensors usually run at 20 Hz and produce a complete point cloud per sweep/measurement-cycle. This leads to a large amount of data per sweep. The data has to be transmitted to the computing system 110 for further processing. If the data is too large (multiple megabytes), data transfer can limit the speed at which the map 130 is generated. Accordingly, to address the technical challenge of the amount of data being generated by the sensors, technical solutions described herein only record the raw data of the LIDAR device, which does not contain a 3D point measurement but only distance and angle information. The recorded data can be compressed in some aspects, for example, using LZ77/Huffman coding, or other data compression algorithms/techniques. This reduces the amount of data by a factor ~5. Furthermore, to reduce the transfer time of the data to the computing system 110 an external storage device (not shown) is plugged into the measurement device 120 where the captured data is stored. In some aspects, for transferring the captured data to the computing system, the external storage is plugged and read into the computing system 110. Alternatively, or in addition, the data that is stored in the external storage is uploaded to the computing system 110 via WIFIO, 4G/5G, or any other type of communication network.

At block 404, the measurement device 120 transmits pose-information of the measurement device 120 to the computing system. At block 405, the mapping module 210 of the computing system 120 performs mapping to generate a 3D point cloud 300 of the surrounding using the captured data 125, calibration data, and pose information based on one or more SLAM algorithms. Further, at block 406, the 3D point cloud 300 may be colorized. The 3D point cloud 300 is stored in the model storage 230. The storage can include updating the map 300 of the surrounding environment 500 that is stored in the model storage 230 by appending the 3D point cloud 300 in the stored map 300.

As noted herein, the scanning system 100 can facilitate mobile mapping, and in turn, to capture several environments given the flexibility of mapping compared to stationary scanning. Mobile mapping can be used to generate point clouds by scanning an environment from the outside (e.g., exterior of a structure, like a building) or from the inside (e.g., interior of the structure). Further, mobile mapping enables to scan nonplanar trajectories like staircases, multiple levels (i.e., floors, e.g., in a multi-storied structure). At present, when generating the map 130 using the scanning system 100, state-of-the-art mapping algorithms implement a global optimization for detecting loop closures, in which similar areas (i.e., portions of the point clouds) are identified and assumed to be connected by a constraint. Based on the constraint, the mapping algorithm overlays the portions (which are deemed to be of the same/similar areas) on top of each other. However, such implementations lead to an inconsistent trajectory causing incorrect point clouds, in at least some situations. For example, when scanning an architecture, like a building, where two or more portions have substantially similar structure (e.g., parking garage, office building, shopping complex, industrial complex, assembly line, warehouse, data center, etc.), the two (distinct, but similar in appearance) portions can be overlayed by the mapping algorithm, because the two scanned portions are (erroneously) deemed to be of the same area/section of the environment. A similar situation can arise in the case of a multi-storied/multi-level architecture/structure, like a building where two or more floors have a similar structure, and a first scanned portion of a first section of a first level is deemed to be the same as a second scanned portion of a second section of a second level. Another situation where such (erroneous) overlaying of scanned portions can occur is with staircases, where two or more scanned staircases are deemed to be the same portion by the mapping algorithm.

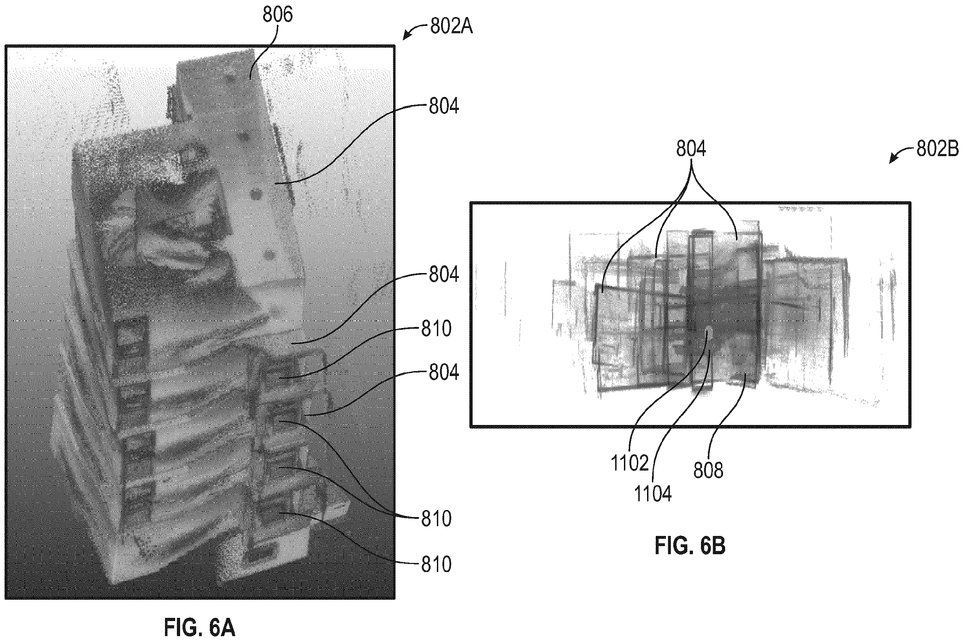

FIGS. 6A and 6B depict an example scenario that illustrates the technical challenge described with present mapping algorithms. In the illustration, view 802A shows a point cloud 806 of a building that is composed of several portions 804. Each portion 804 represents a floor or level of the building. Consider that each portion 804 (i.e., floor) was captured and registered with the other portions 804 to create the point cloud 806. In the depicted point cloud 806, a portion 804 is connected to next portion 804 by a staircase 810. In some aspects, each portion 804 can be a submap, each including one or more portions captured by the scanning system 100. In some aspects, the staircases 810 can be separate portions (804). Alternatively, each staircase 810 can be a part of a corresponding portion 804. The staircase 810 is used to register one portion 804 (floor) with the next portion 804, in some aspects.

The view 802B shows a point cloud 808 of the same building that is depicted in the view 802A. The point cloud 808 is composed of the same portions 804 that are used to generate the point cloud 806. However, in the point cloud 808, the portions 804 are not registered correctly; rather, the staircases 810 are overlayed (i.e., overlapped) on each other. In some cases, as noted herein, the staircases 810 are overlayed on each other because of their (geometric) similarity. The mapping algorithm (erroneously) deems the staircases 810 to be the same portion and adds a constraint that the staircases 810 are the same region/area, and in turn, overlays the staircases 810 onto each other. The resulting point cloud 808 is an incorrect depiction of the environment being scanned.

The technical solutions described herein address such technical challenge by identifying and removing such erroneous constraint(s). In one or more aspects, the technical solutions described herein facilitate identify the inconsistent constraints, e.g., connecting multiple staircases 810, using measurements from the IMU 126. The "implosion effect" as seen in the view 802B is prevented by one or more aspects of the technical solutions herein in this manner. It is understood that although some examples herein are described using a "building," aspects of the technical solutions herein are not limited to any particular architecture/structure of the environment, and can be used for measuring/scanning/capturing any of

A technical challenge with using the IMU measurements is that the IMU 126 experiences drifting. Such drifting error can result in misalignment of the portions 804. For example, as can be seen in the view 802A, the portions 804 representing the floors in the point cloud 806 are individually rotated by a few degrees relative to each other. Such misalignment is the result of the drifting experienced by the IMU 126.

Aspects of the technical solutions described herein address not only the "implosion effect," but also the IMU drifting related technical challenges. Aspects of the technical solutions described herein facilitate differentiating between single-level constraints (i.e., constraints to be applied on a single level/floor) and multi-level constraints (i.e., constraints to be applied among two or more separate layers, and not on the same layer). A single-level constraint can include actual similarities that are physically located on the same floor. If similar portions are found and captured on the same floor, such similar portions are connected, i.e., registered with each other. Multi-level constraints can include similarities among portions of physically different floors (e.g., staircase at floor 1 and floor 2 are almost identical). For such portions, aspects of the technical solutions described herein add to the mapping algorithm a condition: Try to optimize the relative rotation of both similar parts so that both parts have eventually a relative rotation of 0 as well as are located exactly on top of each other (x-y translation is 0 as well). The z-Coordinates of both similar portions are left as is.

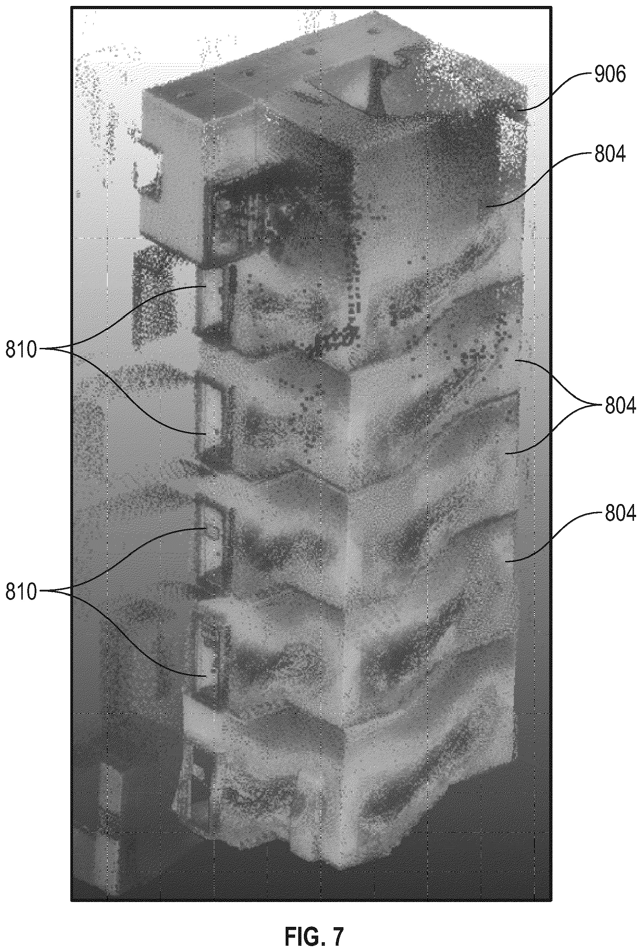

FIG. 7 depicts a resulting point cloud 906 that is created using the same portions 804 as those in FIGS. 6A and 6B, but by applying aspects of the technical solutions described herein. As can be seen, in the point cloud 906, all levels/floors are aligned on the x-y plane correctly and the height of individual levels is correct as well. The resulting point cloud 906 is an improved quality compared to the point clouds 806 and 808. Accordingly, aspects of the technical solutions described herein enable to address the technical challenges described herein and to generate an improved point cloud.

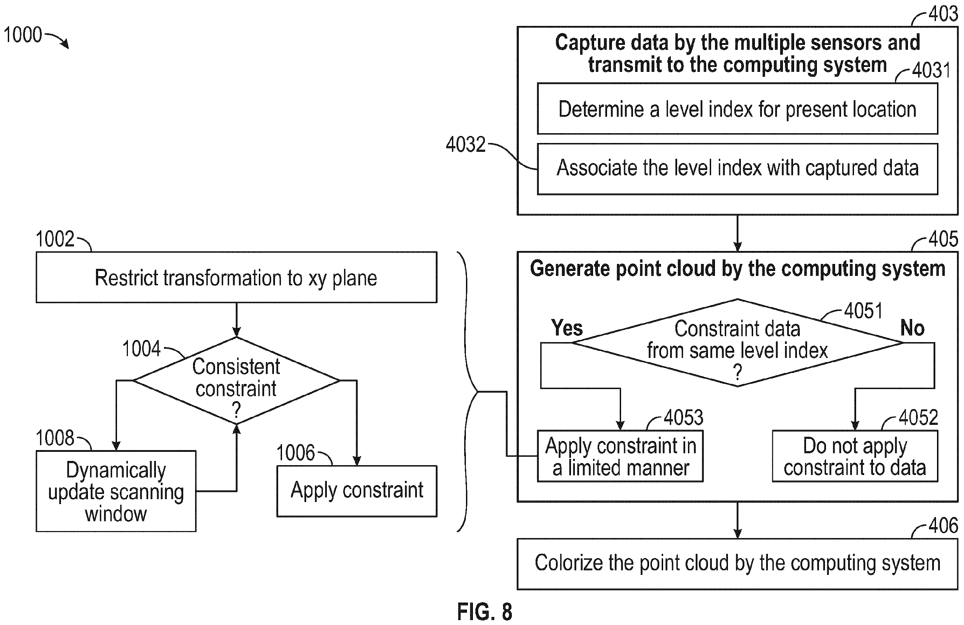

FIG. 8 depicts a flowchart of a method to create single-level and multi-level constraints according to one or more aspects. The depicted method 1000 builds on the operations described in the context of method 400, which are not repeated here for conciseness. At the block 403, as described herein, the scanning system 100 captures data of the environment using the one or more sensors. In one or more aspects, at block 4031, a level index is determined for the present location of the scanning system 100 in the environment being scanned (e.g., building). The level index is used to keep track of the data at each level in the building.

In one or more aspects, the level index is generated automatically, based on a measurement from the IMU 126. For example, when the scanning system 100 is initiated, an initial level index may be set for the data being captured. The level index can be 0 or 1 (or any other whole number). The initial level index can be set to 1 by default in some examples, under the assumption that typically, the first level (level 1) will be scanned first by an operator. The level index value can be configured by the operator if s/he starts scanning the environment at a different level. For example, if the operator starts scanning at a second level, s/he can change the initial level index to 2. The altitude of the scanning system 100 is estimated and associated with the initial level index, in some aspects. For example, the IMU measurement can be used to calculate an estimated altitude of the scanning system 100. Alternatively, or in addition, the scanning system 100 may include an orientation sensor that may fuse data from a 3-axis accelerometer, 3-axis gyroscope, 3-axis magnetometer (e.g., a MARG sensor for Magnetic, Angular Rate, and Gravity), and 1-axis altimeter to estimate orientation and altitude (i.e., height) of the scanning system 100. As the operator moves through the environment, the estimated altitude is monitored. If the estimated altitude changes by at least a threshold, the level index is updated accordingly. For example, if the altitude at initial level is A, and if the threshold is P, then, the level index is incremented by 1 when the altitude increases by P; and the level index is decremented by 1 when the altitude decreases by P. Here, the threshold is an estimated height of a floor/level of the building. In some aspects, the threshold P is configurable.

In yet other examples, if it is determined that a staircase (810) is being traversed (upward/downward), the level index is automatically updated accordingly. In some examples, the scanning system 100 can detect that a staircase (810) is being traversed by the operator based on the data being captured, for example, by the LIDAR and/or the camera. The staircase can be detected using computer vision techniques, such as image detection and recognition, using algorithms that are known or developed in the future.

Alternatively, or in addition, the z-coordinate (height) change in the trajectory as well as expected z-coordinate drift caused by the LIDAR sensors is monitored to determine if the operator has changed levels. For example, if during a predetermined duration (e.g., 10 seconds, 5 seconds, etc.) the z-coordinate continuously increases (or decreases) above a threshold that is typically expected, the scanning system 100 can deem that the operator is traversing from one level to another.

In other examples, the operator can update the level index every time s/he moves from one level to another. In some aspects, the level index is determined automatically, and a prompt is generated for the operator to confirm the level index every time the level index is changed.

At block 4032, the level index is associated with the captured data. The captured data includes the point cloud captured by the LIDAR, along with one or more images (e.g., texture), and any other data used to create the point cloud and the map 130. Additionally the IMU data is associated with each single captured data. Associating the level index with the captured data can include storing the level index in the header, or any other part of the metadata associated with the captured data. For example, if the captured data, e.g, point cloud is stored as part of a digital file, the level index is stored as part of the metadata of the digital file. In other aspects, the level index and the captured data (e.g., digital file) are linked to each other using another file, database, folder, or other such mapping techniques in data storage. In some aspects, the linking is performed in the memory (RAM) during the mapping before even writing out the output. Further, in some other aspects, the level index is transmitted with the captured data in the case of a distributed computing being used to analyze the captured data (as described herein).

In some aspects, the level index is associated with captured data at the time a change in the level index is observed. For example, once the level index changes, the previous level index value is associated with the captured data that has not yet been associated with a level index. The new (changed) level index value is noted and further data is captured. In other aspects, the level index is stored with every LIDAR measurement, as the data is captured.

Further, at block 405, generating the point cloud includes applying the one or more constraints to similar looking portions, as described herein. The similar looking portions from the captured data can be identified using several techniques, such as feature detection and matching. In aspects of the technical solutions herein, the constraints are applied selectively. At block 4051, it is determined whether two portions that have been deemed to be similar looking (e.g., based on feature matching) are from the same level. The determination about the same level is based on the level index associated with the two portions.

At block 4052, if the two portions are deemed to be from different levels (i.e., different level index), the constraint is not applied.

At block 4053, if the two portions are deemed to be from the same level (i.e., same level index), the constraint is applied. However, the constraint is applied in a limited manner so that the two portions are adjusted only on the XY plane, and not on the Z plane (i.e., no changes made to height) (1002). The transformation calculation based on the constraint is limited to the XY plane only (1002). For example, the two portions can be rotated relative to each other on the XY plane (around Y axis), but cannot be tilted (i.e., rotated around X axis, or Y axis). Here, a right hand coordinate system is assumed, and the axes can change if a different coordinate system is used. Accordingly, the constraint can change the two portions on a level, but not change the height information between two portions. Accordingly, the implosion effect (802B) is prevented, however, the IMU drift is compensated for by applying the constraint, albeit in a limited manner.

In some aspects, applying the constraint can further include identifying and restricting inconsistent constraints based on a neighborhood constraint (1004). Because several portions of the map 130 that is generated during the mapping cover similar looking areas (e.g., around the columns, walls, cubicles, storage spaces, cabinets, etc.) even on the same level, in some cases, the constraints may not be applicable to two (or more portions) that look similar, but are not for the same area in the environment. In such cases, a part of the map 130 can be incorrectly moved almost to the other (similar looking) part. Aspects of the technical solutions herein also address this technical challenge by recognizing consistent constraints across neighboring portions. According to the aspects herein, if a constraint is connecting two portions of the map 130, a neighboring constraint is identified and the relative transformations of the present constraint and the neighboring constraint are compared.

For example, consider that the user walks from location A to location B and from B over to location C, and back to A. This results in a loop. If mapping generates a transformation AtoB that is similar to inverse (BtoCtoA) it can be deemed that there is a consistent constraint. Else the algorithm has to identify a similarity from A to B by connecting both parts together, but walking from B over C to A would show that this transformation would differ from the AtoB transformation. Hence, in this case it is considered an inconsistent constraint, i.e., the AtoB constraint is inconsistent, and hence, to be dropped.

If one constraint is an "inconsistent constraint," the transformations would differ from each other. If both constraints are "consistent constraints," the transformations are similar. Here, a transformation includes a transformation matrix or vector. Comparing the transformation includes comparing the transformation matrix or vector, and determining if the difference exceeds a predetermined threshold. The predetermined threshold is also a matrix or a vector, in some aspects. If the constraint is deemed consistent, i.e., the difference does not exceed the predetermined threshold, the constraint is applied to cause the corresponding portion to be adjusted for IMU drift (1006). Alternatively, if the difference exceeds or is equal to the predetermined threshold, the constraint is deemed to be inconsistent with the neighboring constraint, and hence, the constraint is not applied. Instead, in some aspects, in the case of the inconsistent constraints (1008), the scanning window of the scanning system 100 is dynamically updated, and the search for new constraint conducted on a larger area. The larger the area, higher the chance to find consistent constraint. For example, instead of capturing an area of dimensions W1xH1, the scanning system 100 scans an area of dimensions W2xH2. It should be noted that in some aspects, only W1 may be changed; or only H1 may be changed. The change increases the size of the window. Alternatively, or in addition, in some aspects, the density of LIDAR points captured by the scanning system 100 is dynamically changed.

The same constraint consistency check (1004) is repeated for the newly captured data for the portion being scanned. If the newly captured data continues to result in an inconsistent constraint, the above steps are repeated, i.e., scanning window changed and constraint consistency checked again. Such a loop is iterated for a predetermined number of times, or until consistent constraint is obtained, in some aspects.

Accordingly, aspects of the technical solutions described herein facilitate to filter inconsistent constraints.

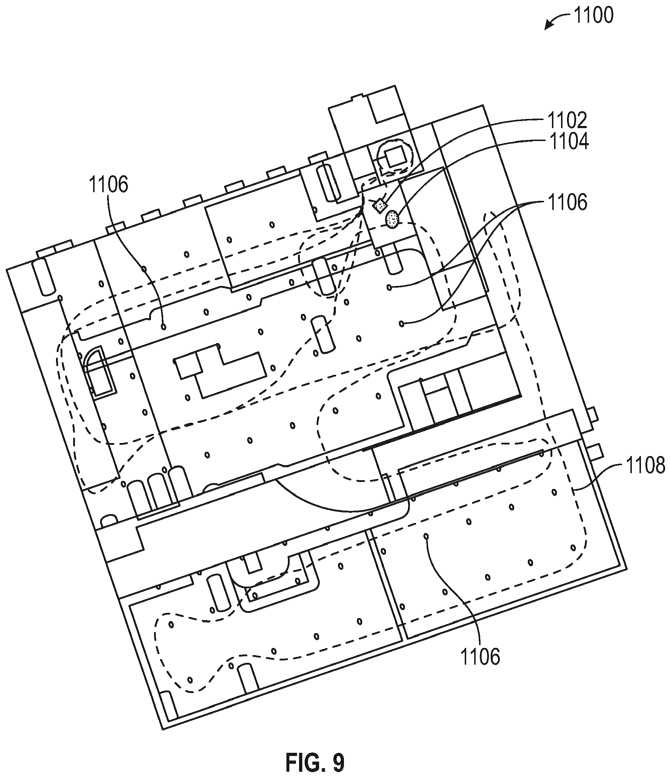

FIG. 9 depicts an example scenario where constraints are filtered based on being consistent or inconsistent according to one or more aspects. A point cloud 1100 is depicted of an environment, such as a parking garage, in which multiple levels/floors have similar structure, and hence, look similar. Further, in the environment, each level includes areas/portions/sections, such as columns 1106, which have similar structure. The areas, like the columns 1106, therefore, look similar to each other. To perform a mobile mapping of the environment, an operator may start from the starting point 1102, follow a path 1108, and circle back to an ending point 1104. The operator scans and captures data along the path 1108. As can be seen, several portions of the environment, such as the columns 1106, may be result in inconsistent constraints. The aspects of the technical solutions described herein prevents the mapping algorithm from connecting such similar portions, which are on the same level (i.e., same index level).

Refering to the method 1000, once the point cloud/map 130 is generated in this manner, the method can continue with further steps, such as colorization (406), in some aspects.

Terms such as processor, controller, computer, DSP, FPGA are understood in this document to mean a computing device that may be located within an instrument/scanner, distributed in multiple elements throughout an instrument/scanner, or placed external to an instrument/scanner.

In one or more aspects, the captured data 125 can be used to generate a map 130 of the environment in which the measurement device 120 is being moved. The computing device 110 and/or the computing device 150 can generate map 130. Map 130 can be generated by combining several instances of the captured data 125, for example, submaps. Each submap can be generated using SLAM, which includes generating one or more submaps corresponding to one or more portions of the environment. The submaps are generated using the one or more sets of measurements from the sets of sensors 122. The submaps are further combined by the SLAM algorithm to generate map 130.

It should be noted that a "submap" is a representation of a portion of the environment and that map 130 of the environment includes several such submaps "stitched" together. Stitching the maps together includes determining one or more landmarks on each submap that is captured, and aligning and registering the submaps with each other to generate map 130. In turn, generating each submap includes combining or stitching one or more sets of captured data 125 from the measurement device 120. Combining two or more captured data 125 requires matching or registering one or more landmarks in the captured data 125 being combined.

Here, a "landmark" is a feature in the environment that can be detected in the captured data 125, and which can be used to register a point from a first captured data 125 with a point from a second captured data 125 being combined. For example, the landmark can facilitate registering a 3D point cloud with another 3D point cloud or registering an image with another image. Here, the registration can be done by detecting the same landmark in the two captured data 125 (images, point clouds, etc.) that are to be registered with each other. A landmark can include but is not limited to features such as an edge, a corner, a doorknob, a door, a lamp, a fire extinguisher, or any other such identification mark that is not moved during the scanning of the environment. The landmarks can also include stairs, windows, decorative items (e.g., plants, picture-frames, etc.), furniture, or any other such structural or stationary objects. In addition to such "naturally" occurring features, i.e., features already present in the environment being scanned, landmarks can also include "artificial" landmarks added by the operator of the measurement device 120. Such artificial landmarks can include identification marks reliably captured and used by the measurement device 120. Examples of artificial landmarks can include predetermined markers or targets, such as labels of known dimensions and patterns, e.g., a checkerboard pattern, a target sign, spheres, or other such preconfigured markers.

In the case of some of the measurement devices 120, such as a volume scanner, the computing device 110, 150 can implement SLAM while building the scan to localize the device and prevent the measurement device 120 from losing track of where it is in 3D space by virtue of its motion uncertainty because there is no presence of an existing map of the environment (the map is being generated simultaneously). It should be noted that in the case of some types of measurement devices 120, SLAM is not performed. For example, in the case of a laser scanner 120, the captured data 125 from the measurement device 120 is stored without performing SLAM.

It should be noted that although the description of implementing SLAM is provided, other uses of the captured data (2D images and 3D scans) are possible in other aspects of the technical solutions herein.

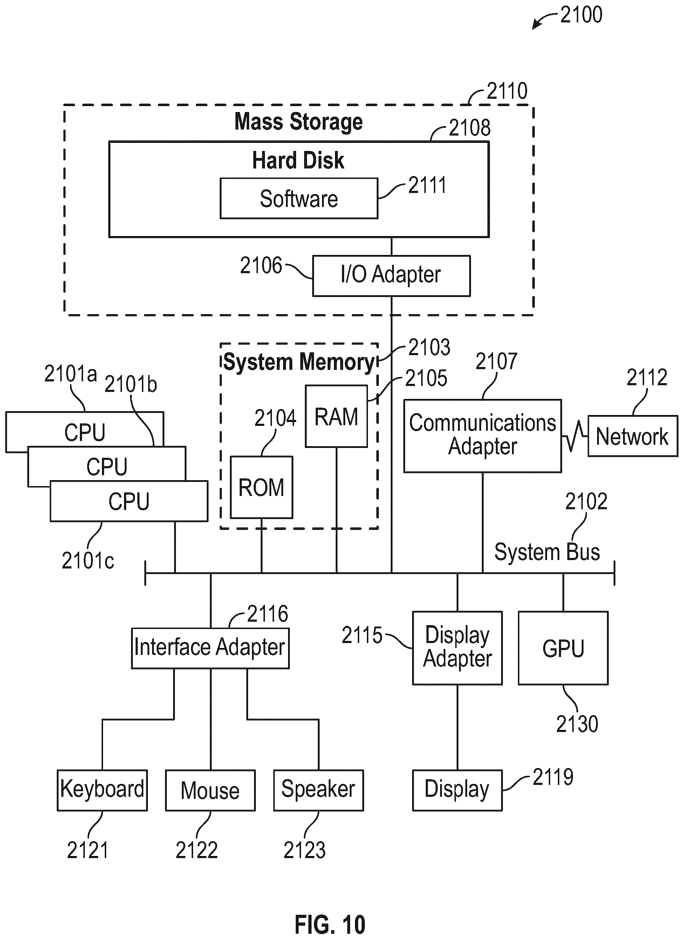

Turning now to FIG. 10, a computer system 2100 is generally shown in accordance with an aspect. The computer system 2100 can be used as the computing device 110 and/or the computing device 150. The computer system 2100 can be an electronic, computer framework comprising and/or employing any number and combination of computing devices and networks utilizing various communication technologies, as described herein. The computer system 2100 can be easily scalable, extensible, and modular, with the ability to change to different services or reconfigure some features independently of others. The computer system 2100 may be, for example, a server, desktop computer, laptop computer, tablet computer, or smartphone. In some examples, computer system 2100 may be a cloud computing node. Computer system 2100 may be described in the general context of computer system executable instructions, such as program modules, being executed by a computer system. Generally, program modules may include routines, programs, objects, components, logic, data structures, and so on that perform particular tasks or implement particular abstract data types. Computer system 2100 may be practiced in distributed cloud computing environments where tasks are performed by remote processing devices that are linked through a communications network. In a distributed cloud computing environment, program modules may be located in both local and remote computer system storage media, including memory storage devices.

As shown in FIG. 10, the computer system 2100 has one or more central processing units (CPU(s)) 2101a, 2101b, 2101c, etc. (collectively or generically referred to as processor(s) 2101). The processors 2101 can be a single-core processor, multi-core processor, computing cluster, or any number of other configurations. The processors 2101, also referred to as processing circuits, are coupled via a system bus 2102 to a system memory 2103 and various other components. The system memory 2103 can include a read-only memory (ROM) 2104 and a random access memory (RAM) 2105. The ROM 2104 is coupled to the system bus 2102 and may include a basic input/output system (BIOS), which controls certain basic functions of the computer system 2100. The RAM is read-write memory coupled to the system bus 2102 for use by the processors 2101. The system memory 2103 provides temporary memory space for operations of said instructions during operation. The system memory 2103 can include random access memory (RAM), read-only memory, flash memory, or any other suitable memory system.

The computer system 2100 comprises a graphics processing unit (GPU) 2130 that can include one or more processing cores and memory devices. The GPU can be used as a co-processor by the processors 2101 to perform one or more operations described herein.

The computer system 2100 comprises an input/output (I/O) adapter 2106 and a communications adapter 2107 coupled to the system bus 2102. The I/O adapter 2106 may be a small computer system interface (SCSI) adapter that communicates with a hard disk 2108 and/or any other similar component. The I/O adapter 2106 and the hard disk 2108 are collectively referred to herein as mass storage 2110.

Software 2111 for execution on the computer system 2100 may be stored in the mass storage 2110. The mass storage 2110 is an example of a tangible storage medium readable by the processors 2101, where the software 2111 is stored as instructions for execution by the processors 2101 to cause the computer system 2100 to operate, such as is described hereinbelow with respect to the various Figures. Examples of computer program product and the execution of such instruction is discussed herein in more detail. The communications adapter 2107 interconnects the system bus 2102 with a network 2112, which may be an outside network, enabling the computer system 2100 to communicate with other such systems. In one aspect, a portion of the system memory 2103 and the mass storage 2110 collectively store an operating system, which may be any appropriate operating system to coordinate the functions of the various components shown in FIG. 10.

Additional input/output devices are shown as connected to the system bus 2102 via a display adapter 2115 and an interface adapter 2116. In one aspect, the adapters 2106, 2107, 2115, and 2116 may be connected to one or more I/O buses that are connected to the system bus 2102 via an intermediate bus bridge (not shown). A display 2119 (e.g., a screen or a display monitor) is connected to the system bus 2102 by a display adapter 2115, which may include a graphics controller to improve the performance of graphics-intensive applications and a video controller. A keyboard 2121, a mouse 2122, a speaker 2123, etc., can be interconnected to the system bus 2102 via the interface adapter 2116, which may include, for example, a Super I/O chip integrating multiple device adapters into a single integrated circuit. Suitable I/O buses for connecting peripheral devices such as hard disk controllers, network adapters, and graphics adapters typically include common protocols, such as the Peripheral Component Interconnect (PCI). Thus, as configured in FIG. 10, the computer system 2100 includes processing capability in the form of the processors 2101, and storage capability including the system memory 2103 and the mass storage 2110, input means such as the keyboard 2121 and the mouse 2122, and output capability including the speaker 2123 and the display 2119.

In some aspects, the communications adapter 2107 can transmit data using any suitable interface or protocol, such as the internet small computer system interface, among others. The network 2112 may be a cellular network, a radio network, a wide area network (WAN), a local area network (LAN), or the Internet, among others. An external computing device may connect to the computer system 2100 through network 2112. In some examples, an external computing device may be an external web server or a cloud computing node.

It is to be understood that the block diagram of FIG. 10 is not intended to indicate that the computer system 2100 is to include all of the components shown. Rather, the computer system 2100 can include any appropriate fewer or additional components not illustrated in FIG. 10 (e.g., additional memory components, embedded controllers, modules, additional network interfaces, etc.). Further, the aspects described herein with respect to computer system 2100 may be implemented with any appropriate logic, wherein the logic, as referred to herein, can include any suitable hardware (e.g., a processor, an embedded controller, or an application specific integrated circuit, among others), software (e.g., an application, among others), firmware, or any suitable combination of hardware, software, and firmware, in various aspects.

It will be appreciated that aspects of the present disclosure may be embodied as a system, method, or computer program product and may take the form of a hardware aspect, a software aspect (including firmware, resident software, microcode, etc.), or a combination thereof. Furthermore, aspects of the present disclosure may take the form of a computer program product embodied in one or more computer-readable medium(s) having computer-readable program code embodied thereon. Methods herein can be computer-implemented methods.

One or more computer-readable medium(s) may be utilized. The computer-readable medium may be a computer-readable signal medium or a computer-readable storage medium. A computer-readable storage medium may be, for example, but not limited to, an electronic, magnetic, optical, electromagnetic, infrared, or semiconductor system, apparatus, or device, or any suitable combination of the foregoing. More specific examples (a non-exhaustive list) of the computer-readable storage medium would include the following: an electrical connection having one or more wires, a portable computer diskette, a hard disk, a random access memory (RAM), a read-only memory (ROM), an erasable programmable read-only memory (EPROM or Flash memory), an optical fiber, a portable compact disc read-only memory (CD-ROM), an optical storage device, a magnetic storage device, or any suitable combination of the foregoing. In one aspect, the computer-readable storage medium may be a tangible medium containing or storing a program for use by or in connection with an instruction execution system, apparatus, or device.

A computer-readable signal medium may include a propagated data signal with computer-readable program code embodied therein, for example, in baseband or as part of a carrier wave. Such a propagated signal may take any of a variety of forms, including, but not limited to, electromagnetic, optical, or any suitable combination thereof. A computer-readable signal medium may be any computer-readable medium that is not a computer-readable storage medium and that can communicate, propagate, or transport a program for use by or in connection with an instruction execution system, apparatus, or device.

The computer-readable medium may contain program code embodied thereon, which may be transmitted using any appropriate medium, including but not limited to wireless, wireline, optical fiber cable, RF, etc., or any suitable combination of the foregoing. In addition, computer program code for carrying out operations for implementing aspects of the present disclosure may be written in any combination of one or more programming languages, including an object oriented programming language such as Java, Smalltalk, C++, or the like and conventional procedural programming languages, such as the "C" programming language or similar programming languages. The program code may execute entirely on the user's computer, partly on the user's computer, as a stand-alone software package, partly on the user's computer, and partly on a remote computer, or entirely on the remote computer or server.

It is further understood that the drawings herein are not to scale and are for illustrative purposes. In one or more aspects, the components described herein can be arranged, scaled, and/or organized differently without moving away from the spirit of the technical solutions described herein to achieve the same technical solutions described herein.

It will be appreciated that aspects of the present disclosure are described herein with reference to flowchart illustrations and/or block diagrams of methods, apparatus (systems), and computer program products according to aspects. It will be understood that each block or step of the flowchart illustrations and/or block diagrams, and combinations of blocks or steps in the flowchart illustrations and/or block diagrams, can be implemented by computer program instructions. These computer program instructions may be provided to a processor of a general-purpose computer, special purpose computer, or other programmable data processing apparatus to produce a machine, such that the instructions, which execute via the processor of the computer or other programmable data processing apparatus, create means for implementing the functions/acts specified in the flowchart and/or block diagram block or blocks.

These computer program instructions may also be stored in a computer-readable medium that can direct a computer, other programmable data processing apparatus, or other devices to function in a particular manner, such that the instructions stored in the computer-readable medium produce an article of manufacture, including instructions which implement the function/act specified in the flowchart and/or block diagram block or blocks. The computer program instructions may also be loaded onto a computer, other programmable data processing apparatus, or other devices to cause a series of operational steps to be performed on the computer, other programmable apparatus, or other devices to produce a computer-implemented process such that the instructions which execute on the computer or other programmable apparatus provide processes for implementing the functions/acts specified in the flowchart and/or block diagram block or blocks.

As used herein, unless explicitly indicated otherwise, "mobile mapping" is the process of measuring and collecting geospatial data by a portable or mobile 3D scanning system. The 3D scanning system, according to one or more aspects of the technical solutions described herein, can use a backpack, a trolley, a handheld device, an autonomous robot, or any other mobile form capable of being carried or moved by an operator. The 3D scanning system uses remote sensing systems like LIDAR, TOF sensors, triangulation sensors, structured light sensors, and/or cameras in combination with inertial and navigation sensors, e.g., an inertial measurement unit (IMU), for mobile mapping. Further, as used herein, unless explicitly indicated otherwise, simultaneous localization and mapping (SLAM) is a technique/algorithm that a mobile 3D scanning system uses to incrementally build a map of the surrounding environment while the 3D scanning system is moving or has been moved, simultaneously localizing itself on the map. A "map" is a 2D or 3D representation of the environment measured through the various sensors of the 3D scanning system. In an embodiment, the map is represented internally as a grid map. The grid map is a 2D or 3D arranged collection of cells representing an area of the environment. The grid map stores, for every cell, a probability indicating if the cell area is occupied or not based on the measurement(s) from the 3D scanning system. In some examples, the 3D scanning system can include LIDAR sensors which produce a 3D point cloud as output. Technical solutions are not restricted or limited to specific LIDAR sensors and can include LIDAR sensors from VELODYNE^{®}, OUSTER^{®}, or any other manufacturer.

While embodiments of the invention have been described in detail in connection with only a limited number of embodiments, it should be readily understood that embodiments of the invention are not limited to such disclosed embodiments. Rather, embodiments of the invention can be modified to incorporate any number of variations, alterations, substitutions or equivalent arrangements not heretofore described, but which are commensurate with the spirit and scope of the invention. Additionally, while various embodiments of the invention have been described, it is to be understood that aspects of the invention may include only some of the described embodiments. Accordingly, embodiments of the invention are not to be seen as limited by the foregoing description, but is only limited by the scope of the appended claims.

## Claims

1. A mobile three-dimensional (3D) measuring system, comprising:
a 3D measuring device configured to capture 3D data in a multi-level architecture;
an orientation sensor configured to estimate an altitude of the 3D measuring device; and
one or more processing units coupled with the 3D measuring device and the orientation sensor, the one or more processing units configured to perform a method comprising:
receiving a first portion of the 3D data captured by the 3D measuring device;
determining a level index based on the altitude estimated by the orientation sensor, the level index indicates a level of the multi-level architecture at which the first portion of the 3D data is captured;
associating the level index with the first portion; and
generating a map of the multi-level architecture using the first portion, the generating comprises registering the first portion with a second portion of the 3D data responsive to the level index of the first portion being equal to the level index of the second portion.

2. The system of claim 1, wherein the 3D measuring device comprises a LIDAR sensor to capture a digital representation of the multi-level architecture as the 3D measuring system is transported in the multi-level architecture.

3. The system of claim 1, wherein the 3D measuring device continuously transmits a captured data to a computing system as the 3D measuring device is moved in the multi-level architecture, the computing system comprising the one or more processing units.

4. The system of claim 3, wherein the computing system generates a 3D point cloud representing the multi-level architecture based on the captured data and stores the 3D point cloud.

5. The system of claim 3, wherein the 3D measuring device is configured for wireless communication with the computing system.

6. The system of claim 1, wherein the orientation sensor comprises a gyroscope, an accelerometer, and magnetometer.

7. The system of claim 1, wherein determining the level index for the first portion comprises:
monitoring the altitude estimated by the orientation sensor;
incrementing a previous level index in response to the altitude estimated by the orientation sensor increasing at least by a predetermined threshold; and
decrementing the previous level index in response to the altitude estimated by the orientation sensor decreasing at least by the predetermined threshold.

8. The system of claim 7, wherein the previous level index is an initial level index that is configured prior to scanning the multi-level architecture and according to the level at which the scanning is initiated.

9. The system of claim 1, wherein determining the level index for the first portion comprises an operator entering the level index.

10. The system of claim 1, wherein the level index is associated with the first portion in response to the level index being changed to a second level index.

11. The system of claim 1, wherein the level index is associated with the first portion captured by the 3D measuring device in a continuous manner.

12. The system of claim 1, wherein associating the level index with the first portion comprises storing the level index in a metadata of a digital representation of the first portion.

13. The system of claim 1, wherein registering the first portion with the second portion comprises:
determining a transformation to be applied to the first portion to compensate for a drifting error;
limiting the transformation to only a horizontal plane; and
transforming the first portion based on the transformation that is limited.

14. The system of claim 13, wherein the transformation is determined based on one or more constraints.

15. The system of claim 14, wherein the one or more constraints are based on one or more corresponding features of the first portion and the second portion.

16. A computer-implemented method comprising:
receiving a first portion of 3D data captured by a 3D measuring device, the 3D data captured in a multi-level architecture;
determining a level index based on an altitude of the 3D measuring device estimated by an orientation sensor, the level index indicating a level of the multi-level architecture at which the first portion of the 3D data is captured;
associating the level index with the first portion; and
generating a map of the multi-level architecture using the first portion, the generating comprises registering the first portion with a second portion of the 3D data responsive to the level index of the first portion being equal to the level index of the second portion.

17. The computer-implemented method of claim 16, wherein the 3D measuring device comprises a LIDAR sensor to capture a digital representation of the multi-level architecture as the 3D measuring system is transported in the multi-level architecture.

18. The computer-implemented method of claim 16, wherein the orientation sensor comprises a gyroscope, an accelerometer, and magnetometer.

19. The computer-implemented method of claim 16, wherein determining the level index for the first portion comprises:
monitoring the altitude estimated by the orientation sensor;
incrementing a previous level index in response to the altitude estimated by the orientation sensor increasing at least by a predetermined threshold; and
decrementing the previous level index in response to the altitude estimated by the orientation sensor decreasing at least by the predetermined threshold,
wherein the previous level index is an initial level index that is configured prior to scanning the multi-level architecture and according to the level at which the scanning is initiated.

20. The computer-implemented method of claim 16, wherein registering the first portion with the second portion comprises:
determining a transformation to be applied to the first portion to compensate for a drifting error;
limiting the transformation to only a horizontal plane; and
transforming the first portion based on the transformation that is limited,
wherein the transformation is determined based on one or more constraints, and wherein the one or more constraints are based on one or more corresponding features of the first portion and the second portion.
